# EUROPEAN PATENT SPECIFICATION

(11) **EP 4 094 889 B1**
(45) Date of publication and mention of the grant of the patent: **26.08.2026**
(21) Application number: 22175094.6
(22) Date of filing: 24.05.2022
(51) Int. Cl.: B24B 37/04, C25F 3/30

(54) **SURFACE PROCESSING METHOD FOR SIC SUBSTRATE**
OBERFLÄCHENBEARBEITUNGSVERFAHREN FÜR SIC-SUBSTRATE
PROCÉDÉ DE TRAITEMENT DE SURFACE DE SUBSTRAT DE SIC

(30) Priority: 25.05.2021 JP 2021087583
(43) Date of publication of application: 30.11.2022
(73) Proprietor: DENSO CORPORATION, Aichi-pref., 448-8661 (JP); OSAKA UNIVERSITY, Suita-shi Osaka 565-0871 (JP)
(72) Inventor: Aoki, Kazufumi, Kariya-city, Aichi-pref., 448-8661 (JP); Maruno, Naoki, Kariya-city, Aichi-pref., 448-8661 (JP); Soltani, Bahman, Kariya-city, Aichi-pref., 448-8661 (JP); Kato, Yuya, Kariya-city, Aichi-pref., 448-8661 (JP); Yamamura, Kazuya, Suita-shi, Osaka, 565-0871 (JP); Yang, Xu, Suita-shi, Osaka, 565-0871 (JP)
(74) Representative: Kuhnen & Wacker Patent- und Rechtsanwaltsbüro PartG mbB

(56) References cited:
- CN-A- 110 197 789
- JP-A- 2014 187 131
- JP-A- 2021 027 359
- JP-B2- 6 041 301
- JP-B2- 6 786 420
- YANG XIAOZHE ET AL: "Dominant factors and their action mechanisms on material removal rate in electrochemical mechanical polishing of 4H-SiC (0001) surface", APPLIED SURFACE SCIENCE, ELSEVIER, AMSTERDAM , NL, vol. 562, 17 May 2021 (2021-05-17), XP086636076, ISSN: 0169-4332, [retrieved on 20210517], DOI: 10.1016/J.APSUSC.2021.150130

## Description

### BACKGROUND

### Technical Field

The present invention relates to a surface processing method for SiC substrates.

### Related Art

JP 2021-27359 A discloses a polishing method utilizing anodization. This polishing method is one in which a difficult-to-process material that can be anodized can be formed into a desired shape with high efficiency and high precision by combining oxidation and polishing. Specifically, in the polishing method, the anodizing process and the polishing process are simultaneously or alternately performed to polish under the condition that the polishing rate by the polishing process is higher than the oxidation rate by the anodizing process. This type of polishing method utilizing anodization is referred to as ECMP. ECMP stands for electrochemical mechanical polishing.

As described in JP 2021-27359 A, it has conventionally been known that when the current density is increased in ECMP, the processing speed is increased while the surface roughness deteriorates. Furthermore, JP 2021-27359 A discloses that, since the oxidation rate is saturated with an increase in the current density, if the current density is increased to a certain value, the polishing rate cannot be increased even if the current density is increased further.

Thus, according to the conventional knowledge, a significant advantage of increasing the current density in ECMP has not been obtained. For example, according to JP 2021-27359 A, the upper limit of a practical current density is at most about 10 mA/cm², and it is used in a rough polishing process preceding the finish polishing process.

Thus, in this type of surface processing method using the principle of the formation of an anodization film and the selective removal of the oxide film, there is still room for further research in order to achieve processing characteristics (for example, processing speed or surface roughness) superior to those of the conventional method. The present invention has been made in view of the circumstances described above. That is, the present invention provides a technique that can realize superior processing characteristics than those in the past, for example, in a surface processing method of a SiC substrate utilizing anodization.

### SUMMARY

A surface processing method for a SiC substrate (W) according to an aspect of the invention includes anodizing a workpiece surface (W1) of the SiC substrate by passing a current having a current density of 15 mA/cm² or more through the SiC substrate as an anode in the presence of an electrolyte (S); and disposing a grinding wheel layer (32) of a surface processing pad (3) to face the workpiece surface and selectively removing, with the grinding wheel layer, an oxide (W3) generated on the workpiece surface through anodization.

In some cases, parenthesized reference numerals are attached to the elements in the sections of the application. In such a case, the reference numerals are merely examples of the correspondence between the same elements and the specific configurations described in the embodiments to be described below. Accordingly, the present invention is not limited in any way by reference numerals.

### BRIEF DESCRIPTION OF THE DRAWINGS

FIG. 1 is a schematic configuration diagram of a surface processing apparatus for implementing a surface processing method according to an embodiment of the present invention;
FIG. 2 illustrates the outline of a SiC wafer manufacturing process that can be accomplished by using the surface processing apparatus illustrated in FIG. 1;
FIG. 3 is scanning electron microscope images of a workpiece surface of an anodized SiC substrate using the surface processing apparatus illustrated in FIG. 1;
FIG. 4 is a schematic cross-sectional view of the structure of a portion in the vicinity of a workpiece surface of the SiC substrate illustrated in FIG. 3;
FIG. 5 is a schematic cross-sectional view of the structure of the SiC substrate illustrated in FIG. 4 after the oxide film is removed by a solution;
FIG. 6 is a graph illustrating the influence of a change in current density on the pit depth illustrated in FIG. 5;
FIG. 7 is a graph illustrating the influence of a change in current density on the pit depth illustrated in FIG. 5;
FIG. 8 is a graph illustrating the influence of a change in current density on the pit depth illustrated in FIG. 5;
FIG. 9 is scanning electron microscope images of a workpiece surface of a SiC substrate when the current density is changed by adjusting the electrolyte concentration;
FIG. 10 is a graph illustrating the measurement result of the surface roughness after the oxide film in each SiC substrate illustrated in FIG. 9 is removed by a solution;
FIG. 11 is scanning electron microscope images of a workpiece surface of a SiC substrate when the electrolyte concentration is changed while the current density is kept constant;
FIG. 12 is scanning electron microscope images of a cross-section of a portion in the vicinity of a workpiece surface of a SiC substrate before and after anodization;
FIG. 13 is a graph illustrating the relationship between current density and surface roughness after polishing;
FIG. 14A is a schematic cross-sectional view of the differences in oxide film formation modes due to changes in current density;
FIG. 14B is a schematic cross-sectional view of the differences in oxide film formation modes due to changes in current density;
FIG. 14C is a schematic cross-sectional view of the differences in oxide film formation modes due to changes in current density;
FIG. 15 is a graph illustrating a simulated result of the effect of pulsing of an applied current on the recovery of OH- concentration during anodization in a region near a workpiece surface of a SiC wafer to be processed;
FIG. 16 is a graph illustrating the result of the trial calculation of the total amount of OH-reaction per unit time based on the simulation result illustrated in FIG. 15;
FIG. 17 is a graph illustrating an experimental result to confirm the increase in the oxidation rate in anodization by pulsing of the applied current;
FIG. 18 is a graph illustrating the relationship between the current density and the processing speed when a pulsed current is applied;
FIG. 19 is a graph illustrating the relationship between the period and the oxidation rate when a pulsed current is applied; and
FIG. 20 is a graph illustrating the relationship between the duty ratio and the oxidation rate when a pulsed current is applied.

### DESCRIPTION OF SPECIFIC EMBODIMENTS

### Embodiments

Embodiments of the present invention will now be described with reference to the drawings.

### Surface Processing Apparatus

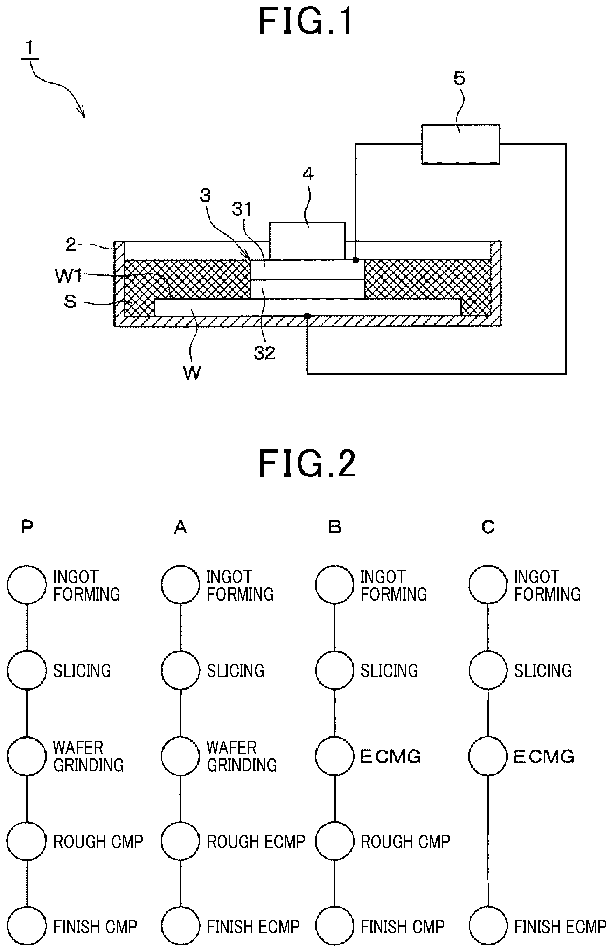

Referring to FIG. 1, a surface processing apparatus 1 according to the present embodiment is a processing apparatus that processes a single crystal SiC wafer or SiC substrate W as a workpiece, and is capable of polishing or grinding processing utilizing anodization on the workpiece surface W1 of the SiC substrate W. That is, the surface processing apparatus 1 has the configuration of an ECMP apparatus or an ECMG apparatus. ECMG stands for electrochemical mechanical grinding.

The surface processing apparatus 1 includes a container 2, a surface processing pad 3, a driving device 4, and a power supply device 5. In the present embodiment, the container 2 can hold the SiC substrate W while the SiC substrate W is immersed in an electrolyte S containing no etchant component. The etchant component is a component (for example, hydrofluoric acid or the like) constituting a solution having an ability to dissolve an oxide film (i.e., SiC oxide formed into a film) formed on the workpiece surface W1 by anodization. The electrolyte S is an aqueous solution of, for example, sodium chloride, potassium chloride, or sodium nitrate.

The surface processing pad 3 includes an electrode 31 and a grinding wheel layer 32. The electrode 31 is a plate-like member composed of a satisfactory conductor, such as metal, and is formed of, for example, a copper plate. The grinding wheel layer 32 is joined to the electrode 31. That is, the surface processing pad 3 has a configuration in which the electrode 31 and the grinding wheel layer 32 are joined in the thickness direction of the surface processing pad 3. The grinding wheel layer 32 has a polishing material having a Mohs hardness that is an intermediate hardness between that of single crystal SiC and an oxide film of the single crystal SiC. That is, the grinding wheel layer 32 is rotated by the driving device 4 while being disposed facing the workpiece surface W1 of the SiC substrate W, so that the oxide film formed on the workpiece surface W1 by anodization can be selectively removed by polishing or grinding. In the present embodiment, the surface processing pad 3 is provided so that the grinding wheel layer 32 is disposed facing the workpiece surface W1 of the SiC substrate W across the electrolyte S.

The driving device 4 rotates the surface processing pad 3 about a predetermined rotation axis parallel to the thickness direction, and relatively shifts the SiC substrate W and the surface processing pad 3 in an in-plane direction orthogonal to the rotation axis. The power supply device 5 applies a voltage by using the SiC substrate W, which is the workpiece, as an anode and the electrode 31 in the surface processing pad 3 as a cathode in the presence of the electrolyte S, to pass a current for anodizing the workpiece surface W1, which is to be processed by the grinding wheel layer 32.

In the present embodiment, the power supply device 5 is provided to make a current having a current density of 15 mA/cm² or more flow through the SiC substrate W as an anode in the presence of the electrolyte S. The power supply device 5 can output a pulsed current having an on-time and an off-time as a current for anodizing the workpiece surface W1. Here, the term "on-time" refers to the time for allowing a current having a current density of 15 mA/cm² or more to flow. The term "off-time" refers to the time during which a current having a current density of 15 mA/cm² or more is not allowed to flow, specifically, the time during which the current is substantially zero. That is, the power supply device 5 is capable of selectively outputting a direct current substantially free of a periodic current density change of a predetermined frequency accompanying a time change and a rectangular pulsed current. In this way, the surface processing apparatus 1 according to the present embodiment has a configuration in which a direct current or a pulsed current having a current density of 15 mA/cm² or more can be used as a current for anodization of the workpiece surface W1, to perform high-speed and high-precision ECMP or ECMG.

### Outline of Surface Processing Method of Embodiment

The surface processing apparatus 1 according to the present embodiment is capable of performing a surface processing method (that is, a polishing method or a grinding method) of the SiC substrate W having the following processing (1) to (3) in order to achieve the processing characteristics (for example, processing speed or flatness) superior to those of the conventional ECMP. The processing (2) and (3) can be performed simultaneously or sequentially.
(1) The surface processing pad 3 is disposed facing the workpiece surface W1 of the SiC substrate W across the electrolyte S.
(2) A direct current or a pulsed current having a current density of 15 mA/cm² or more is made to pass through the SiC substrate W as an anode in the presence of the electrolyte S. This anodizes the workpiece surface W1, which is to be processed by the grinding wheel layer 32.
(3) The workpiece surface W1 is ground or polished with the grinding wheel layer 32. That is, the oxide film (i.e., an oxide formed into a film) formed on the workpiece surface W1 through anodization is selectively removed using the grinding wheel layer 32.

A to C in FIG. 2 are schematic manufacturing process diagrams of a SiC wafer or a SiC substrate W using the surface processing apparatus 1 illustrated in FIG. 1. The conventional method P as a comparative example illustrated FIG. 2 indicates the outline of a manufacturing process of a SiC wafer in which well-known CMP is used in place of ECMP or ECMG by the surface processing apparatus 1 illustrated in FIG. 1. CMP stands for chemical mechanical polishing.

An outline of the conventional manufacturing method P will now be described. The conventional manufacturing method P includes an ingot forming process, a slicing process, a wafer grinding process, a rough CMP process, and a finish CMP process in this order. The ingot forming process is for growing a lump of single crystal SiC and forming the lump into a cylindrical ingot. The slicing process is of obtaining a thin discoid SiC substrate W or SiC wafer from an ingot by wire slicing. The wafer grinding process is for planarizing the SiC substrate W by removing, by grinding, the "undulation" in the SiC substrate W that occurs in the slicing process. The rough CMP process and the finish CMP process are for processing the workpiece surface W1 of the SiC substrate W into a mirror surface, which is a surface state preferable for a semiconductor device manufacturing process.

In general, in the wafer grinding process, a "damaged layer" having a certain degree of "subsurface damage" is formed on the workpiece surface W1 of the SiC substrate W and its vicinity. The "subsurface damage" is, for example, cracking, residual stress, etc. First, the workpiece surface W1 is mirror-finished by in the rough CMP process. The damaged layer is removed by the subsequent finish CMP process.

As disclosed in JP 2017-92497 A, ECMP, which is a damage-free polishing process, achieves a processing speed higher than that of CMP. Thus, by replacing the CMP process with the ECMP process, high-speed and damage-free polishing of the workpiece surface W1 can be accomplished. In the ECMP process, a soft grinding wheel containing relatively soft abrasive grains (e.g., ceria abrasive grains) is used as the grinding wheel layer 32.

Thus, in the present embodiment, for example, as in the manufacturing method A illustrated in FIG. 2, it is possible to replace the rough CMP process in the conventional manufacturing method P with a rough ECMP process, and to replace the finish CMP process in the conventional manufacturing process P with a finish ECMP process. In this way, the manufacturing cost can be reduced by approximately 40% compared with that of the conventional manufacturing method P.

The ECMG process can be accomplished by using a hard grinding wheel containing relatively hard abrasive grains (for example, diamond abrasive grains) as the grinding wheel layer 32. That is, as in the manufacturing method B illustrated in FIG. 2, the wafer grinding process in the conventional manufacturing method P can be replaced with the ECMG process. In this way, the manufacturing cost can be reduced by approximately 20% compared with that of the conventional manufacturing method P.

The ECMG process, which is a low-damage grinding process, reduces the frequency of subsurface damage compared with the wafer grinding process of the conventional manufacturing method P. Thus, when the wafer grinding process in the conventional manufacturing method P is replaced with the ECMG process, the manufacturing method B can be changed to the manufacturing method C. In the manufacturing method C, the rough CMP process in the conventional manufacturing method P is omitted and the finish CMP process in the conventional manufacturing method P is replaced with the finish ECMP process. In this way, the manufacturing cost can be reduced to approximately half of that of the conventional manufacturing method P.

### High Current Density of Anodizing Current

As described in JP 2021-27359 A, it has been known that in ECMP using a SiC substrate W as a workpiece that an increase in the current density leads to an increase in the processing speed but deterioration in the surface roughness. Therefore, conventionally, when ECMP is used in the finish polishing process, the current density is reduced by lowering the applied voltage below the passive potential in order to achieve satisfactory surface roughness after machining while accepting the disadvantage of a reduction in processing speed.

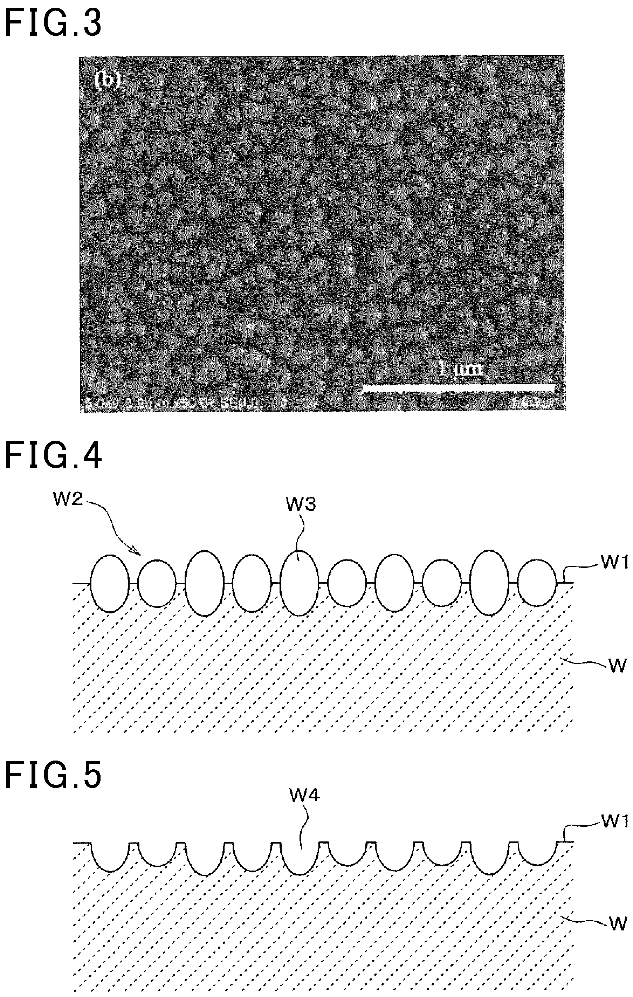

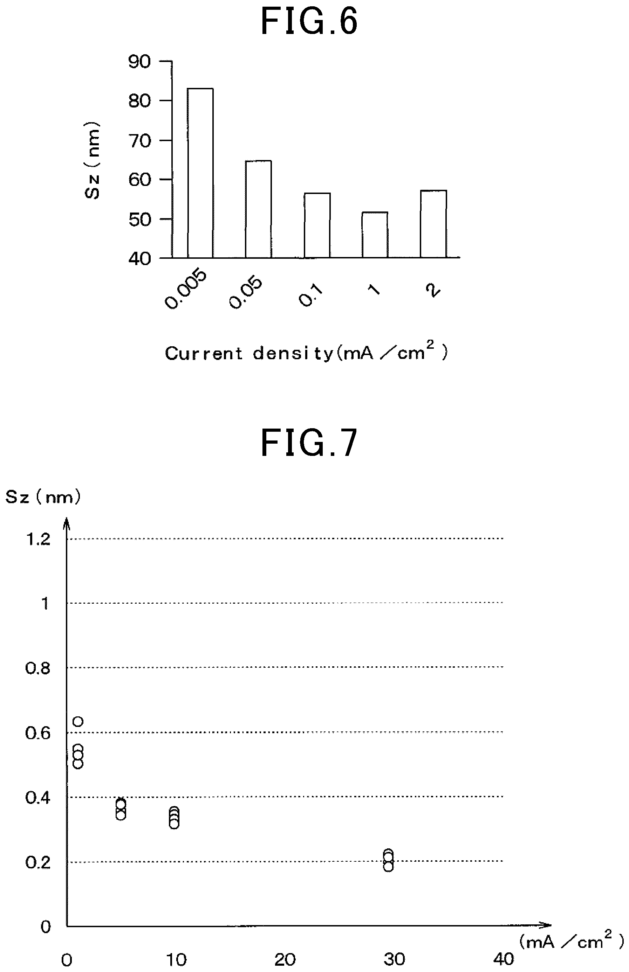

However, as a result of intensive research, the inventors found that the surface roughness can be improved by using a high current density region of 15 mA/cm² or more in which the applied voltage is sufficiently higher than the passive potential, contrary to the conventional knowledge. Specifically, as illustrated in FIGS. 3 and 4, an oxide film W2 formed on the workpiece surface W1 by anodization has an undulated structure composed of many oxide W3 particles. When the oxide film W2 is dissolved in a solution containing an etchant component, such as hydrofluoric acid, many pits W4 are formed on the workpiece surface W1, as illustrated in FIG. 5. The depth of the pits W4 was measured under the condition of a low current density of direct current and constant current corresponding to the finish polishing process based on the conventional knowledge while the current density was varied. The result is illustrated in FIG. 6. The pit depth Sz on the vertical axis in FIG. 6 is the maximum value of the depth of the pits W4 in a predetermined region (1 µm × 1 µm) on the wafer that is the sample, and is measured with an atomic force microscope SPM 9700 manufactured by Shimadzu Corporation. As illustrated in FIG. 6, it was found that the pit depth Sz decreased as the current density increased.

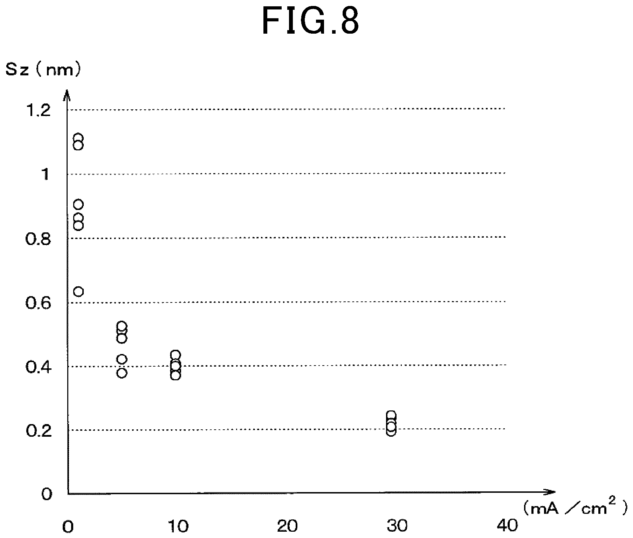

Under the condition of a higher current density, the change of the pit depth Sz with the variation in the current density was found for both the direct current and the pulsed current. The result is illustrated in FIGS. 7 and 8. FIG. 7 illustrates the case of a direct current, i.e., a non-pulse current, and FIG. 8 illustrates the case of a pulsed current. The pit depth Sz under each current condition was measured at five measuring points with approximately equal spacing, including points near the center on a straight line passing through the center on the surface of the wafer that is the sample. As illustrated in FIGS. 7 and 8, in both the direct current and the pulsed current, it was found that the pit depth Sz decreased due to an increase in the current density, that is, the pit shape became uniform, within the range of 5 to 30 mA/cm².

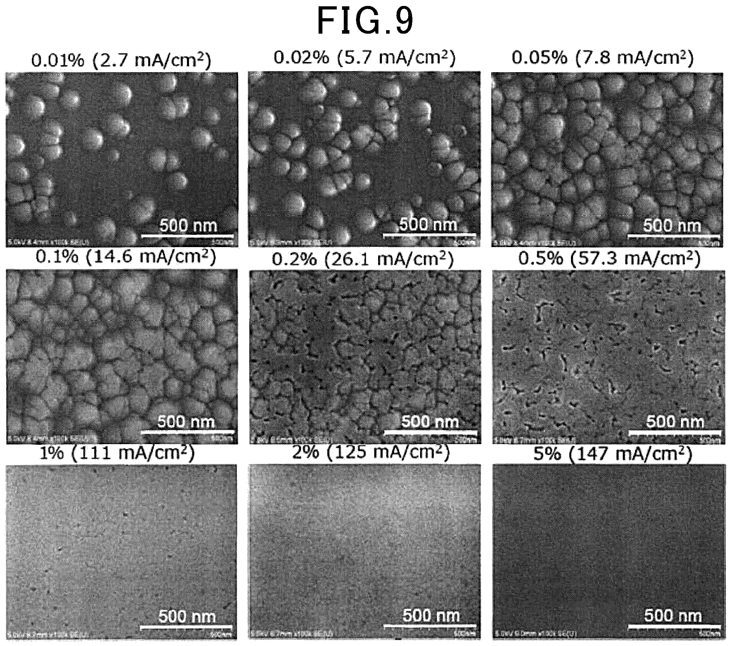

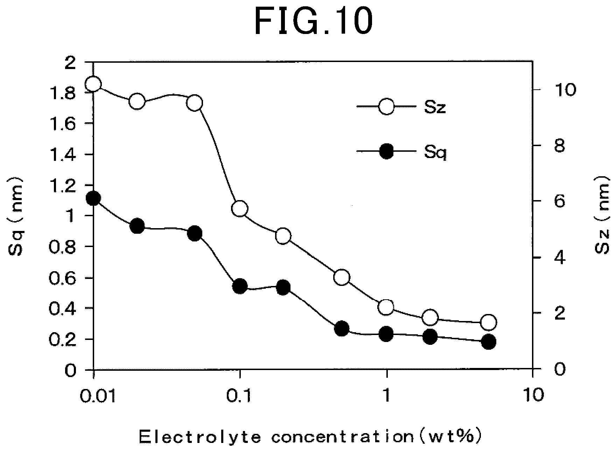

FIG. 9 is scanning electron microscope images of the workpiece surface of the SiC substrate when the current density is changed by adjusting the electrolyte concentration while using a direct current. The application conditions are a voltage of 25 V and an application time of 30 seconds. FIG. 9 illustrates the concentration of the sodium chloride solution or the electrolyte and the corresponding current density. FIG. 10 is a graph illustrating the measurement result of the surface roughness after the oxide film W2 in each SiC substrate illustrated in FIG. 9 is removed by a solution. The maximum height Sz and root mean square height Sq on the vertical axis in FIG. 10 were measured with a scanning white-light interferometer New View 8300 manufactured by ZYGO.

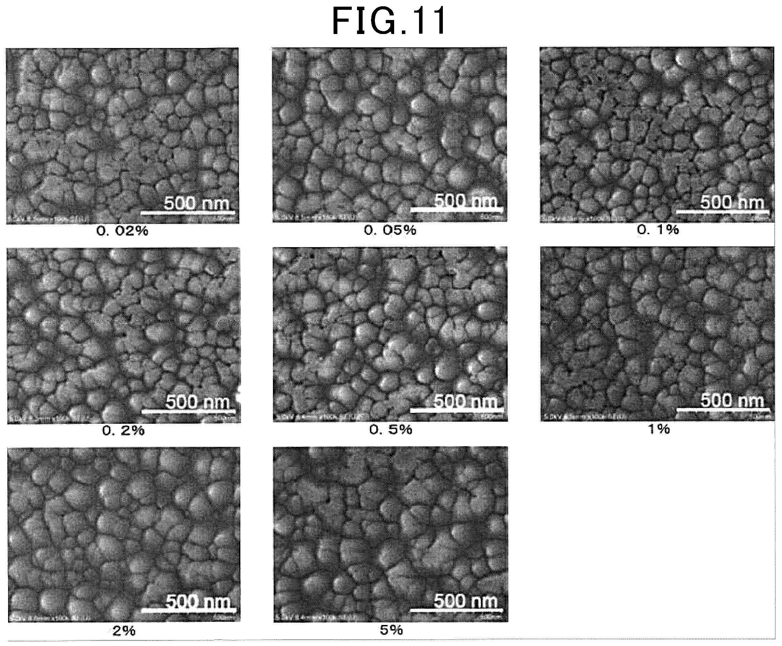

As illustrated in FIGS. 9 and 10, it has been found that increasing the electrolyte concentration increases the current density, reduces the protrusion structure in the oxide film W2, and improves the uniformity of the oxide film W2. In order to verify whether or not this result is due to a variation in the electrolyte concentration rather than a variation in the current density, the result of varying only the electrolyte concentration while keeping the current density constant was obtained. The result is illustrated in FIG. 11. The application conditions are a current density of 10 mA/cm² and an application time of 30 seconds. FIG. 11 illustrates the concentration of the sodium chloride solution or the electrolyte. As illustrated in FIG. 11, it has been found that, even if the electrolyte concentrations differ, there is almost no difference in the surface shape so long as the current density is the same. Thus, as it is apparent from the result of FIGS. 9 to 11, it was found that the uniformity of the oxide film W2 was improved by increasing the current density.

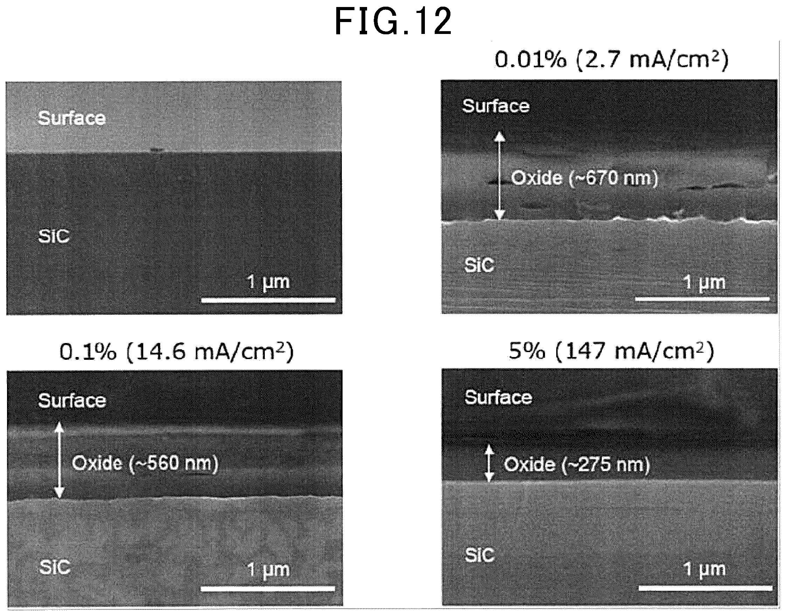

FIG. 12 illustrates the result of observing the cross-sections of the oxide film W2 when the oxide film W2 was anodized at different current densities. The top left of FIG. 12 illustrates the state before the anodization. As it is apparent from the results in FIG. 12, it was found that a dense and uniform oxide film W2 having low undulation was formed by increasing the current density.

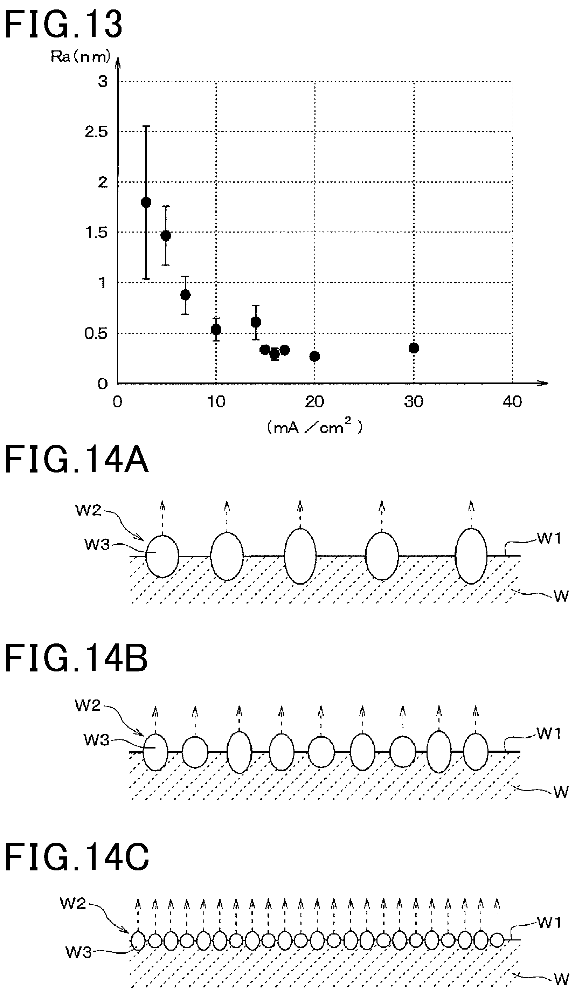

FIG. 13 illustrates the result of a measurement of the surface roughness after polishing by ECMP while the current density was varied when the anodization was performed by using a direct current, not a pulsed current. As it is apparent from the result in FIG. 13, it was found that excellent surface properties could be achieved by using a current density of 15 mA/cm² or more.

FIGS. 14A to 14C schematically illustrate a possible mechanism of the effect of reducing the surface roughness by a high current density. In the drawing, dashed arrows indicate an anodizing current. As illustrated in FIGS. 14A to 14C, it is considered that the higher the current density, the more uniform the current flow state in the in-plane direction (i.e., the left-right direction in the drawing) and the denser the structure of the oxide film W2.

In this way, the oxide film W2 becomes satisfactorily dense and uniform by a high current density. A high current density can lead to an increase in the processing speed. Therefore, the present embodiment can provide a technique that can achieve more superior processing characteristics than those in the past, for example, in a surface processing method of a SiC substrate W utilizing anodization. In other words, according to the present embodiment, it is possible to provide high-speed and high-precision ECMP or ECMG.

### Processing Conditions

Various processing conditions in the surface processing method according to the present embodiment will now be described.
(1) The surface processing method according to the present embodiment includes a process of setting an anodizing condition so that the current density in the anodization of the workpiece surface W1 is 15 mA/cm² or more. The anodizing conditions to be set include at least one of the following parameters: the temperature and concentration of the electrolyte S, the output current value from the power supply device 5, the output current waveform, the output voltage value, the output voltage waveform, etc. Specifically, for example, the electric resistance value of the electrolyte S can be adjusted by the temperature and/or concentration of the electrolyte S. This makes it possible to hold a desired anodizing current in a satisfactory manner. Here, the term "anodizing current" refers to an applied current for anodizing, that is, the portion of a current flowing into the SiC substrate W from the power supply device 5 that is actually used for the anodization of the workpiece surface W1, not for the electrolysis of the electrolyte S. Pulsing of a current will be described below.
(2) As described above, the surface processing method according to the present embodiment can be applied to both ECMP and ECMG. That is, the grinding wheel layer 32 grinds or polishes the workpiece surface W1 anodized by the application of a current. The grinding rate or polishing rate can be adjusted by the type and number of the grinding wheel in the grinding wheel layer 32. Specifically, for example, by using a diamond grinding wheel of #8000 to #30,000, a grinding rate of 5 µm/min or more can be achieved. Alternatively, for example, by using a ceria grinding wheel having a number of about #8000, it is possible to achieve a polishing rate of 5 µm/h or more.
(3) It is preferable that the removal rate of the oxide W3 (i.e., the oxide film W2) by the grinding wheel layer 32 (i.e., the polishing rate or the grinding rate) be substantially equal to the oxidation rate of anodizing the workpiece surface W1. In this way, the surface roughness of the processed workpiece surface W1 can be satisfactorily reduced.
(4) As in the manufacturing method A illustrated in FIG. 2, the rough ECMP process and the finish ECMP process at a polishing rate lower than that of the rough ECMP process may be performed in this order. In such a case, anodization can be performed in the rough ECMP process and the finish ECMP process under the same current density condition. Similarly, as in the manufacturing method C illustrated in FIG. 2, the ECMG process and the ECMP process may be performed in this order. In such a case, anodization can be performed in the ECMG process and the ECMP process under the same current density condition. In this way, by applying the high current density condition to the grinding process, the rough polishing process, and the finish polishing process, the SiC planarization process can be made as consistent as possible.

### Improvement of Oxidation Rate by Current Pulsing

In the ECMP in which a SiC substrate is used as a workpiece, the inventors have found that even if the current density is increased to increase the processing speed, there is a problem that the increase in the processing speed is limited because the oxidation rate in anodization saturates. According to the examination by the inventors, the cause of the saturation of the increase in the oxidation rate accompanying the increase in the current density is considered to be a shortage in the supply of reactive species, that is, OH-, in the electrolyte S in the vicinity of the workpiece surface W1. The region in the vicinity of the workpiece surface W1 is hereinafter referred to as "near-surface region."

Specifically, the consumption of OH- by anodization in the near-surface region causes a decrease in the OH- concentration. Then, OH- is supplied from a bulk region of the electrolyte S, that is, a region farther from the workpiece surface W1 than the near-surface region, to the near-surface region according to the principle of material diffusion. Thus, the OH- concentration in the near-surface region decreases as it approaches the workpiece surface W1 according to Fick's law.

Whether or not the supply of OH- in the near-surface region is sufficient depends on the relationship between the oxidation rate, i.e., the consumption rate of OH-, and the supply rate of OH- from the bulk region. In this regard, when the current condition in the anodization is a direct current and constant current, there is a concern that the supply rate of OH- is insufficient, so that the supply of OH- in the near-surface region is insufficient, and, thus, it becomes difficult to maintain a stable anodization state.

The inventors found that the oxidation rate is improved by providing the applied current for anodization as a pulsed current having an on-time and an off-time, and supplying OH- from the bulk region to the near-surface region during the off-time to recover the OH- concentration in the near-surface region. The inventors also found that by setting the off-time relatively short (specifically, for example, about 0.01 to 10 seconds), it is possible to satisfactorily avoid an increase the total processing time while maintaining a satisfactory oxidation rate during the on-time.

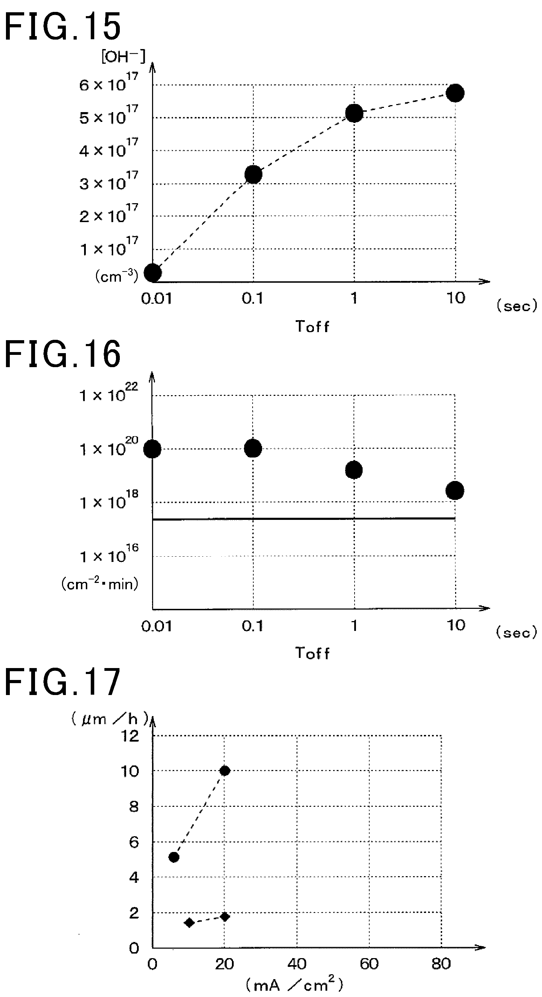

FIG. 15 is a result of a computer simulation showing the effect on the recovery of OH-concentration in the near-surface region by providing an off-time for the anodizing current. In the drawing, "Toff " on the horizontal axis indicates the length of the off-time. The vertical axis indicates the OH- concentration at a position 10 µm away from the workpiece surface W1, which is presumed to be a flat surface. The precondition of the simulation are as follows: $Diffusion coefficient D = 1.9 x {10}^{- 9} {m}^{2} / s$ $Bulk region OH - concentration C = 6.02 \times {10}^{17} {cm}^{- 3}$

FIG. 16 illustrates the result of the trial calculation of the total amount of OH-reaction per unit time based on the simulation results illustrated in FIG. 15. The horizontal solid line in the drawing indicates a case of Toff = 0, that is, direct current and constant current. The term "direct current and constant current" is hereinafter simply referred to as "constant current."

As it is apparent from FIGS. 15 and 16, the supply shortage of OH- in the near-surface region can be satisfactorily eliminated by providing an off-time of 0.01 seconds or more using the anodizing current as a pulsed current. Specifically, as illustrated in FIGS. 15 and 16, the inventors have found through simulation that it is possible to satisfactorily supply OH- to the near-surface region in the off-time of 0.01 seconds or more and 10 seconds or less. However, the effect of the recovery of the OH- concentration by providing the off-time tends to saturate in a region where the Toff is relatively long. Thus, it is considered more preferable that the off-time be approximately 0.1 to 1 second.

The inventors conducted an experiment using a 30-mm square wafer to determine the difference in the oxidation rate in anodization between the constant current application and the pulsed current application. The pulsed current has a rectangular waveform with an on-time of one second and an Off-time of one second (that is, a cycle of two seconds and a duty ratio of 0.5). After the anodizing treatment, an oxide film W2 was removed with hydrofluoric acid, and the oxidation rate was calculated by the amount of removal. The experimental results are illustrated in FIG. 17. In FIG. 17, the plotted circle points represent the case of a pulsed current and the plotted rhomboid points represent the case of a constant current. The value of the current density in the case of the pulsed current is the value during the on-time.

As apparent in FIG. 17, pulsed current application achieves a high oxidation rate within the range of high to low current density regions. As the current density increases, the oxidation rate also increases. Thus, when a pulsed current is applied, the processing speed can be satisfactorily increased by increasing the current density. In particular, even if a large amount of OH- in the near-surface region is consumed by applying a current having a high current density, the OH- concentration in the near-surface region can be satisfactorily recovered during the Off-time. Thus, by applying a pulsed current, it is expected that high-speed processing can be achieved by applying a current having a high current density.

### Improvement of Processing Speed by Current Pulsing

The processing speed is affected not only by the oxidation rate but also by the property of the oxide film W2. Specifically, in the conventional ECMP, the oxide film W2 having relatively high density and relatively high hardness is formed by applying a constant current having a relatively low current density. When the composition of the oxide film W2 formed by the application of a constant current corresponding to the conventional ECMP was analyzed by an XPS apparatus, the oxide film contained approximately 40% SiOC, approximately 30% SiO, and approximately 10% Si₂O₃. XPS stands for X-ray photoelectron spectroscopy.

In contrast, when the composition of the oxide film W2 formed by the application of a pulsed current was analyzed with an XPS apparatus, the content of SiOC was significantly lower than that of the oxide film W2 formed by the application of a constant and low current, while the content of SiO was significantly higher. When the cross-section was observed with a transmission electron microscope, the formation of an internal void layer was more significant in the oxide film W2 formed by the application of a pulsed current than in the oxide film formed by the application of a constant and low current. There was a tendency for an increase in the pulse period to lead to an increase in the number of voids in the void layer. Specifically, under the condition of a duty ratio of 0.5, the generation of a void layer was more significant in the case of the application of a constant and low current even in the case of a period of 0.02 seconds, and the amount of the voids increased as the period increased, for example, from 0.1 seconds to one second. That is, the inventors found that an oxide film W2 that can be easily polished or ground at a relatively low density was formed within a period of 0.02 to 1 second.

In consideration with the above results, the following matters are considered as the effects of pulsed current application. Since OH- is satisfactorily supplied to the near-surface region and the anodization of SiC is promoted, more SiO with a more progressed degree of oxidation than that of SiOC is generated. As the degree of oxidation progresses in the order of SiOC and SiO, the expansion coefficient becomes larger, and the generation of voids due to internal stress in the oxide film W2 is promoted. Thus, the formation of the void layer caused by the difference in the expansion coefficient before and after oxidation becomes more significant as a result of more SiO being generated. In this way, the oxide film W2 containing a large amount of SiO and having an increased number of voids in the void layer has low hardness, and the rate of grinding or polishing increases. When many cracks occur on the surface of the oxide film W2 due to the generation of voids, OH-, which is a reactive species, enters the inside of the film through the cracks, and the anodization may be further promoted. As described above, an effect of increasing the polishing rate can be expected as an effect of the pulsing of the applied current.

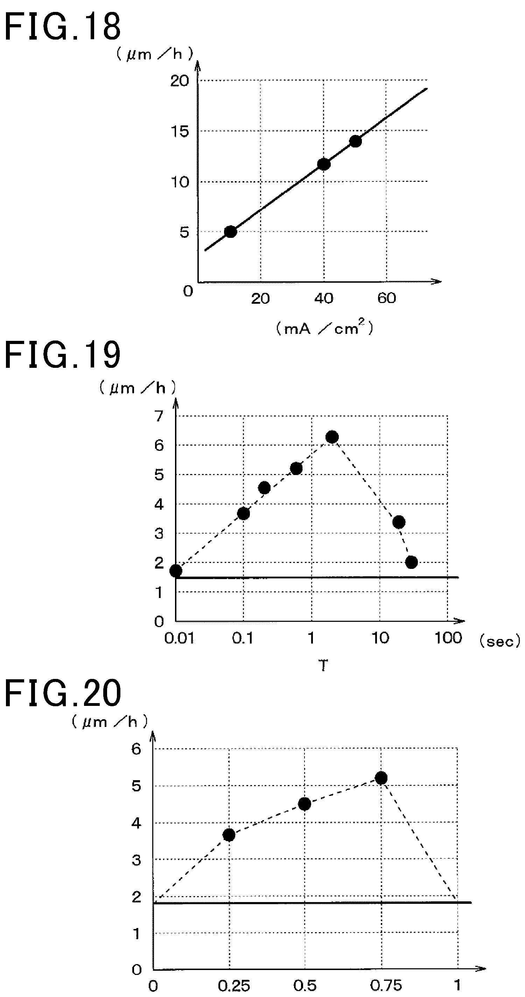

FIG. 18 illustrates the relationship between the current density and the polishing rate when the current density in the application of a pulsed current is varied. The pulsed current has a period of two seconds and a duty ratio of 0.75. A 10.2 cm (4-inch) wafer was used as a polishing target. The method of calculating the polishing rate is as follows: Variation in the thickness of the 10.2 cm (4-inch) wafer that is the sample was measured at nine measurement points at equal intervals along the straight line passing through the center of the wafer surface before and after polishing, and the average value of the thickness variation in a unit time at the nine measuring points was calculated to be the polishing rate of the wafer. As illustrated in FIG. 18, in the case of pulsed current application, it was found that the polishing rate increased with an increase in the current density even in a high current region of 40 mA/cm² or more.

### Pulse Period

FIG. 19 illustrates a change in the oxidation rate when the period of the pulsed current is changed. In the drawing, the vertical axis indicates the oxidation rate, and the horizontal axis T indicates the period. The horizontal solid line in the drawing indicates a reference value for a case of a constant current.

The evaluation conditions are as follows: A 30-mm square wafer was used as a sample. The duty ratio, the current density, and the application time were made the same in order to match the charge amount between the respective current application conditions. The duty ratio was 0.5, and the current density was 20 mA/cm².

As it is apparent from FIG. 19, an oxidation rate higher than that of the constant current was obtained within a period range of at least 0.01 to 20 seconds. Here, as described above, in order to recover the OH- concentration in the near-surface region, it is necessary to provide an Off-time of 0.01 seconds or more. Thus, the period for obtaining a satisfactory oxidation rate is over 0.01 seconds and 20 seconds or less. In particular, when the period is 0.01 seconds, the off-time is 0.005 seconds, so that the oxidation rate is slightly higher than that of the case of a constant current. Thus, for example, if the duty ratio is 0.25 to 0.75 at the minimum value of 0.01 seconds of the off-time as described below, the minimum value of a suitable period is approximately 0.02 seconds.

As described above, in consideration of the satisfactory processability due to the formation of the low-density oxide film, the period is preferably within the range of 0.02 to 1 second. As illustrated in FIG. 19, in the region in which the period exceeds 20 seconds, the oxidation rate is slightly higher than in the case of a constant current. It is considered that the reason for this is that while the effect of an increase in the oxidation rate by providing an off-time is saturated as described above, the overall cycle time is prolonged. Thus, in consideration of the simulation results illustrated in FIGS. 15 and 16, the evaluation results of the actual oxidation rate illustrated in FIG. 19, and the cycle time in the actual manufacturing process, it is preferable that the period is 0.1 seconds or more and 2 seconds or less.

In overall consideration of the above, a preferred period is 0.02 to 2 seconds, more preferably 0.02 to 2 seconds, more preferably 0.02 to 1 second or 0.1 to 2 seconds, and most preferably 0.1 to 1 second.

### Duty Ratio

FIG. 20 illustrates a change in the oxidation rate when the duty ratio of the pulsed current is changed. In the drawing, the vertical axis indicates the oxidation rate, and the horizontal axis T indicates the duty ratio. The horizontal solid line in the drawing indicates a reference value for a case of a constant current.

The evaluation conditions are as follows: A 30-mm square wafer was used as a sample. In order to match the charge amount between the respective current application conditions, the current densities were set to be the same (i.e., 20 mA/cm²), and the application time was adjusted so that the product of the duty ratio and the application time was constant. As illustrated in FIG. 20, by setting the duty ratio within the range of 0.25 to 0.75, a satisfactory oxidation rate higher than the constant current was achieved.

### Summary of Effects of Current Pulsing

As described above, pulsation of the applied current in the anodization can lead to not only an increase in the oxidation, but also improvement in the polishability and the grindability associated with the decrease in the density and the hardness of the oxide film W2, and improvement in the flatness by improvement in the uniformity of the oxide film W2. Thus, the rate of polishing or grinding can be increased, and the wafer manufacturing cost can be reduced.

That is, for example, contrary to the conventional common knowledge that increasing the current density increases the processing rate while deteriorating the surface roughness, increasing the applied pulsed current to a high current can achieve high-speed processing while maintaining a satisfactory flatness. As described above, the inventors have found the formation of a satisfactory oxide film W2 suitable for ECMP or ECMG at a current density of up to approximately 150 mA/cm².

Regarding the wafer size, it is possible to achieve a similar polishing rate even when the diameter is further increased from four inches as in the above-described embodiment. Specifically, the surface processing method according to the present embodiment is satisfactorily applicable to wafer size, for example, within the range of 2.54 cm to 20.32 cm (1 to 8 inches).

### Modifications

The present invention is not limited to the above embodiments, but only to the appended claims. Therefore, the above embodiments can be modified as appropriate. Typical modifications will be described below. In the following description of the modifications, differences from the above embodiment will be mainly described. In the above-described embodiments and the modifications, the same reference numerals are assigned to portions that are the same or equal to each other. Therefore, in the description of the following modifications, the description of the above-described embodiments may be appropriately incorporated with respect to components having the same reference numerals as those of the above-described embodiments, unless there is a technical contradiction or a special additional description.

The present invention is not limited to the specific device configuration described in the above embodiments. That is, FIG. 1 is a simplified schematic diagram for simply explaining the outline of the surface processing apparatus 1 according to the present invention and the surface processing method that can be performed by the apparatus 1. Therefore, the configuration of the surface processing apparatus 1 actually manufactured and sold does not necessarily match the exemplary configuration illustrated in FIG. 1. The configuration of the surface processing apparatus 1 actually manufactured and sold can be appropriately modified from the exemplary configuration illustrated in FIG. 1.

For example, the configuration of the surface processing pad 3 is not limited to the specific device configuration described in the above embodiment. Specifically, the electrode 31 and the grinding wheel layer 32 need not be joined in the thickness direction of the surface processing pad 3. More specifically, for example, the electrode 31 and the grinding wheel layer 32 may be disposed adjacent to each other in the in-plane direction orthogonal to the thickness direction of the surface processing pad 3. That is, the surface processing apparatus 1 may have a configuration in that the surface processing pad 3 rotates or moves such that the electrode 31 and the surface processing pad 3 alternately face a specific portion of the workpiece surface W1 in time. Alternatively, the electrode 31 may be a separate body from the surface processing pad 3. That is, the surface processing apparatus 1 can be configured such that the electrode 31 and the surface processing pad 3 are disposed to temporally alternately face the whole or a specific portion of the workpiece surface W1. The type of abrasive grains contained in the grinding wheel layer 32 is not particularly limited.

The electrolyte S may contain an etchant component. That is, the surface processing apparatus 1 according to the present invention and the surface processing method that can be performed by the surface processing apparatus 1 may be one in which the workpiece surface W1 is polished or ground by selectively removing the oxide film W2 generated by the anodization using both the etchant and the surface processing pad 3.

The surface processing apparatus 1 according to the present invention and the surface processing method that can be performed by the surface processing apparatus 1 are typically applied to any of the ECMG process, the rough ECMP process, and the finish ECMP process in the manufacturing methods A to C illustrated in FIG. 2. However, for example, in the manufacturing method A, it can be expected that the workpiece surface W1 after the rough ECMP process is satisfactorily mirror-finished and has minor subsurface damage caused by the rough ECMP process. Thus, it is possible to use the ECMP with conventional constant current application for the finish ECMP process.

## Claims

1. A method of processing a surface of a SiC substrate (W), comprising:
anodizing a workpiece surface (W1) of the SiC substrate by passing a pulsed current having a current density between 15 mA/cm² and 150 mA/cm² through the SiC substrate as an anode in the presence of an electrolyte (S), the pulsed current having an on-time and off-time, a length of the off time being set such that the concentration of reactive species in the vicinity of the workpiece surface consumed during the on time is recovered during the off time; and
disposing a grinding wheel layer (32) of a surface processing pad (3) to face the workpiece surface and selectively removing, with the grinding wheel layer, an oxide (W3) formed on the workpiece surface through anodization.

2. . The method according to claim 1, wherein the on-time is set for passing the current having a current density of 15 mA/cm² or more and the off-time is set for not passing the current having a current density of 15 mA/cm² or more.

3. . The method according to any one of claims 1 or 2, wherein a removal rate of the oxide with the grinding wheel layer is equal to an oxidation rate in the anodization of the workpiece surface.

4. . The method according to any one of claims 1 to 3, wherein the grinding wheel layer grinds or polishes the workpiece surface anodized by application of the current.

5. . The method according to claim 4, wherein the selective removal of the oxide with the grinding wheel layer comprises:
grinding the workpiece surface at a grinding rate of 5 µm/min or more; and
polishing the workpiece surface at a polishing rate of 5 µm/h or more.

6. . The method according to claim 5, further comprising:
performing anodization corresponding to the grinding of the workpiece surface and anodization corresponding to the polishing of the workpiece surface under the same current density condition.

7. . The method according to claim 5 or 6, further comprising:
performing anodization corresponding to the rough polishing and anodization corresponding to the finish polishing under the same current density condition,
wherein the selective removal of the oxide with the grinding wheel layer comprises:
rough polishing of the workpiece surface; and
finish polishing of the workpiece surface at a polishing rate lower than the polishing rate of the rough polishing.

8. . The method according to any one of claims 1 to 7, further comprising:
performing, simultaneously or sequentially, the anodization of the workpiece surface and the selective removal of the oxide with the grinding wheel layer.

## Patentansprüche

1. Verfahren zum Bearbeiten einer Oberfläche eines SiC-Substrats (W), umfassend:
anodisches Oxidieren einer Werkstückoberfläche (W1) des SiC-Substrats, indem ein gepulster Strom mit einer Stromdichte zwischen 15 mA/cm² und 150 mA/cm² durch das SiC-Substrat als Anode in Gegenwart eines Elektrolyten (S) geleitet wird, wobei der gepulste Strom eine Einschaltzeit und eine Ausschaltzeit aufweist und eine Länge der Ausschaltzeit derart eingestellt ist, dass die Konzentration reaktiver Spezies in der Umgebung der Werkstückoberfläche, die während der Einschaltzeit verbraucht werden, während der Ausschaltzeit wiederhergestellt wird; und
Anordnen einer Schleifscheibenschicht (32) eines Oberflächenbearbeitungskissens (3) derart, dass sie der Werkstückoberfläche zugewandt ist, und selektives Entfernen eines auf der Werkstückoberfläche durch anodische Oxidation gebildeten Oxids (W3) mit der Schleifscheibenschicht.

2. . Verfahren nach Anspruch 1, wobei die Einschaltzeit so eingestellt ist, dass der Strom mit einer Stromdichte von 15 mA/cm² oder mehr geleitet wird, und die Ausschaltzeit so eingestellt ist, dass der Strom mit einer Stromdichte von 15 mA/cm² oder mehr nicht geleitet wird.

3. . Verfahren nach einem der Ansprüche 1 oder 2, wobei eine Abtragsrate des Oxids mit der Schleifscheibenschicht gleich einer Oxidationsrate bei der anodischen Oxidation der Werkstückoberfläche ist.

4. . Verfahren nach einem der Ansprüche 1 bis 3, wobei die Schleifscheibenschicht die durch Anlegen des Stroms anodisch oxidierte Werkstückoberfläche schleift oder poliert.

5. . Verfahren nach Anspruch 4, wobei das selektive Entfernen des Oxids mit der Schleifscheibenschicht umfasst:
Schleifen der Werkstückoberfläche mit einer Schleifrate von 5 µm/min oder mehr; und
Polieren der Werkstückoberfläche mit einer Polierrate von 5 µm/h oder mehr.

6. . Verfahren nach Anspruch 5, ferner umfassend:
Durchführen einer anodischen Oxidation entsprechend dem Schleifen der Werkstückoberfläche und einer anodischen Oxidation entsprechend dem Polieren der Werkstückoberfläche unter derselben Stromdichtebedingung.

7. . Verfahren nach Anspruch 5 oder 6, ferner umfassend:
Durchführen einer anodischen Oxidation entsprechend dem Grobpolieren und einer anodischen Oxidation entsprechend dem Feinpolieren unter derselben Stromdichtebedingung,
wobei das selektive Entfernen des Oxids mit der Schleifscheibenschicht umfasst:
Grobpolieren der Werkstückoberfläche; und
Feinpolieren der Werkstückoberfläche mit einer Polierrate, die niedriger als die Polierrate des Grobpolierens ist.

8. . Verfahren nach einem der Ansprüche 1 bis 7, ferner umfassend:
Durchführen, gleichzeitig oder nacheinander, der anodischen Oxidation der Werkstückoberfläche und des selektiven Entfernens des Oxids mit der Schleifscheibenschicht.

## Revendications

1. Un procédé de traitement d'une surface d'un substrat en SiC (W), comprenant :
anodiser une surface de pièce à traiter (W1) du substrat en SiC en faisant passer un courant pulsé ayant une densité de courant comprise entre 15 mA/cm² et 150 mA/cm² à travers le substrat en SiC servant d'anode en présence d'un électrolyte (S), le courant pulsé présentant un temps de conduction et un temps de coupure, la durée du temps de coupure étant réglée de telle sorte que la concentration en espèces réactives au voisinage de la surface de la pièce à usiner, consommée pendant le temps de conduction, soit rétablie pendant le temps de coupure ; et
disposer une couche de meule (32) d'un tampon de traitement de surface (3) en regard de la surface de la pièce à usiner et éliminer de manière sélective, à l'aide de la couche de meule, un oxyde (W3) formé sur la surface de la pièce à usiner par anodisation.

2. . Le procédé selon la revendication 1, dans lequel le temps de conduction est défini de manière à laisser passer un courant présentant une densité de courant égale ou supérieure à 15 mA/cm², et le temps de coupure est défini de manière à ne pas laisser passer un courant présentant une densité de courant égale ou supérieure à 15 mA/cm².

3. . Le procédé selon l'une quelconque des revendications 1 ou 2, dans lequel le taux d'enlèvement de l'oxyde avec la couche de la meule est égal au taux d'oxydation lors de l'anodisation de la surface de la pièce.

4. . Le procédé selon l'une quelconque des revendications 1 à 3, dans lequel la couche de meule polit ou meule la surface de la pièce anodisée par application d'un courant.

5. . Le procédé selon la revendication 4, dans lequel l'élimination sélective de l'oxyde à l'aide de la couche de meule comprend :
moudre la surface de la pièce à une vitesse de meulage de 5 µm/min ou plus ; et
polir la surface de la pièce à une vitesse de polissage de 5 µm/h ou plus.

6. . Le procédé selon la revendication 5, comprenant en outre :
réaliser une anodisation correspondant au meulage de la surface de la pièce et d'une anodisation correspondant au polissage de la surface de la pièce dans les mêmes conditions de densité de courant.

7. . Le procédé selon la revendication 5 ou 6, comprenant en outre :
réaliser une anodisation correspondant au polissage grossier et d'une anodisation correspondant au polissage de finition dans les mêmes conditions de densité de courant,
dans lequel l'élimination sélective de l'oxyde au niveau de la couche de meule comprend :
le polissage grossier de la surface de la pièce ; et
le polissage de finition de la surface de la pièce à une vitesse de polissage inférieure à celle du polissage grossier.

8. . Le procédé selon l'une quelconque des revendications 1 à 7, comprenant en outre :
réaliser, simultanément ou séquentiellement, l'anodisation de la surface de la pièce et de l'élimination sélective de l'oxyde à l'aide de la couche de meule.
